# EUROPEAN PATENT APPLICATION

(11) **EP 2 093 796 A1**
(43) Date of publication of application: **26.08.2009**
(21) Application number: 08161491.9
(22) Date of filing: 30.07.2008
(51) Int. Cl.: H01L 21/8238, H01L 29/51

(54) **Semiconductor device and method for fabricating the same**

(30) Priority: 20.02.2008 US 30160 P
(71) Applicant: IMEC, 3001 Leuven (BE); Taiwan Semiconductor Manufacturing Company, Ltd. (TSMC), Hsinchu 300-077 (TW)
(72) Inventor: Chang, Shou-Zen, Taiwan Semiconductor Manufacturing Company Ltd., 310, Hsinchu Country (TW); Yu, Hong Yu, Interuniversitair Microelektronica Centrum vzw, 639798, Singapore (SG); Hoffmann, Thomas Y., Interuniversitair Microelektronica Centrum vzw, 3000, Leuven (BE)
(74) Representative: Bird, William Edward

(57) **Abstract**

The present invention provides a method for manufacturing a dual work function semiconductor device. The method comprises:
providing a substrate (5) with a first region (I) and a second region (II);
forming a first control electrode stack on the first region (I), the first control electrode stack having a first effective work function, and forming a second control electrode stack on the second region (II), the second control electrode stack having a second effective work function, wherein each control electrode stack comprises a control electrode dielectric and a control electrode. The process of forming the control electrode stacks comprises:
(i) forming a host dielectric layer (1) overlying the first region (I) and the second region (II) of the substrate (5),
(ii) forming a first dielectric capping layer (2) overlying the host dielectric layer (1) on the first region (I) and on the second region (II), wherein the first dielectric capping layer is selected to determine the second effective work function,
(iii) removing at least the first dielectric capping layer (1) selectively to an underlying layer (1; 5) on the first region (I), thereby exposing the underlying layer (1; 5) on the first region (I),
(iv) forming a Hf-based dielectric capping layer (3) overlying the underlying layer (1; 5) on the first region and the first dielectric capping layer (2) on the second region (II), wherein the Hf-based dielectric capping layer (3) is selected to have a healing effect on the exposed surface of the underlying layer (1; 5) on the first region (I), and
(v) forming a control electrode (4) overlaying the Hf-based dielectric capping layer (3) on the first region (I) and on the second region (II).

## Description

### Technical field of the invention

The present invention generally relates to semiconductor devices. More specifically, this invention relates to fabrication of semiconductor devices comprising semiconductor structures comprising a single control electrode and different dielectric materials. In particular, the present invention relates to methods for manufacturing dual work function semiconductor devices and to dual work function semiconductor devices thus obtained. Particularly, the invention may relate to dual work function devices comprising a single metal control electrode and a control electrode dielectric comprising dielectric capping layers. For example, the present invention may relate to complementary metal oxide semiconductor (CMOS) devices.

### Background of the invention

Up to now, semiconductor industry remains driven by scaling geometric dimensions of metal-oxide-semiconductor field-effect-transistors (MOSFETs). With traditional MOSFET technology, using silicon dioxide (SiO₂) as gate dielectric and polycrystalline silicon (poly-Si) as gate material, a lot of problems occur when scaling down to 100 nm or below.

Scaling MOSFETs to improve performance results leads to higher gate leakage as the gate dielectric, e.g. SiO₂ gate dielectric, becomes thinner. To address this issue, SiO₂ gate dielectrics have been replaced with high-k materials (e.g. Hf-based or Al-based material with a k-value larger than the k-value of SiO₂, also called high-k materials, i.e. with a k-value above 3.9). High-k dielectrics allow for a larger physical thickness (compared to SiO₂) for obtaining a same effective capacitance than can be obtained with a much thinner SiO₂ layer. The larger physical thickness of the high-k material will reduce gate leakage currents. With the introduction of the high-k materials, however, a new problem arose, namely the Fermi level pinning effect. Fermi level pinning is a fundamental characteristic of the semiconductor, e.g. polysilicon (polySi)/oxide interface that causes high threshold voltages in MOSFET devices.

A known solution to this problem is the introduction of metal gates. However, it has been proven difficult to identify band-edge metals (metals with either a n-type or a p-type work function (WF), required for low device voltage threshold, Vt) that are compatible with the conventional CMOS fabrication process. CMOS can be made using dual metal gates with single or dual dielectrics. In either case, a selective removal of one of the metal gates is necessary and adds substantial complexity and costs to the manufacturing process. Moreover, after the selective removal process, the interface between the underlying dielectric layer and the metal electrode is often modified/ altered, due to the presence of undesired dangling bonds. This modification may influence the effective work function of the gate stack in an unwanted way.

Another known solution for CMOS manufacturing is to use FUlly Sllicided (FUSI) gates, without a selective removal of electrode or gate dielectric. However, to obtain appreciate WF, FUSI gates require different silicide phases on nMOS and pMOS. On small devices, the phase or composition of the FUSI gate tends to distribute unevenly, resulting in severe within-wafer threshold voltage (Vₜ) non-uniformity.

### Summary of the invention

It is an object of embodiments of the present invention to alleviate or overcome problems and disadvantages of the prior art methods and devices.

The above objective is accomplished by a method and device according to the present invention.

In one aspect, the present invention provides a method for manufacturing a dual work function semiconductor device. The method comprises:
providing a substrate with a first region and a second region;
forming a first control electrode stack on the first region, the first control electrode stack having a first effective work function and forming a second control electrode stack on the second region, the second control electrode stack having a second effective work function, wherein each control electrode stack comprises a control electrode dielectric and a control electrode. According to the present invention, the process of forming the control electrode stacks comprises:
   (i) forming a host dielectric layer overlying the first region and the second region of the substrate,
   (ii) forming a first dielectric capping layer overlying the host dielectric layer on the first region and on the second region, wherein the first dielectric capping layer is selected to determine the second effective work function,
   (iii) removing at least the first dielectric capping layer selectively to an underlying layer on the first region, thereby exposing the underlying layer on the first region,
   (iv) forming a Hf-based dielectric capping layer overlying the underlying layer on the first region and the first dielectric capping layer on the second region, wherein the Hf-based dielectric capping layer is selected to have a healing effect on the exposed surface of the underlying layer on the first region, and
   (v) forming a control electrode overlaying the Hf-based dielectric capping layer on the first region and on the second region.

It is an advantage of embodiments of the present invention that, due to the healing effect of the Hf-based dielectric capping layer on the underlying layer, leakage performance of realised devices is improved.

It is a further advantage of embodiments of the present invention that the Hf-based dielectric capping layer does not need to be removed when further processing dual work function devices.

In embodiments of the present invention, the underlying layer is the host dielectric layer. In alternative embodiments, the underlying layer is the substrate. Both embodiments define different integration routes for the manufacturing methods according to embodiments of the present invention.

In embodiments of the present invention, the first and second region are of different, e.g. opposite, dopant type. In embodiments of the present invention, the first region may be an NMOS region and the second region may be a PMOS region. In this case, the first dielectric capping layer may for example be an Al-based dielectric. In alternative embodiments of the present invention, the first region may be a PMOS region and the second region may be an NMOS region.

In this case the first dielectric capping layer may for example be a lanthanide-based dielectric or an Sc-based dielectric.

In embodiments of the present invention, forming the Hf-based dielectric capping layer may comprise depositing the Hf-based dielectric capping layer, for example by ALD. Depositing the Hf-based dielectric capping layer by ALD may comprise depositing during 1 to 10 cycles ALD.

In embodiments of the present invention, the Hf-based dielectric capping layer may comprise HfLaO. In particular embodiments, the Hf-based dielectric capping layer may consist of HfLaO.

In embodiments of the present invention, the host dielectric layer may be selected from the group consisting of Si02, SiON, Hf02, Zr02 and mixtures thereof.

In embodiments of the present invention, forming a control electrode may comprise forming a first control electrode in the first region, and forming a second control electrode in the second region. The first electrode and the second electrode may be formed of a same layer of electrode material. Therefore, the first electrode and the second electrode may have the same thickness and material composition. In embodiments of the present invention, forming a control electrode may comprise forming a metal control electrode.

In another aspect, the present invention provides a dual work function semiconductor device, comprising a first transistor on a first region of a substrate, the first transistor having a first effective work function, and a second transistor on a second region of the substrate, the second transistor having a second effective work function. The first transistor comprises an underlying layer, a control electrode and a Hf-based dielectric capping layer sandwiched in between the underlying layer and the control electrode. The second transistor comprises a host dielectric layer overlying and in contact with the substrate, a control electrode, a first dielectric capping layer overlying the host dielectric layer and a Hf-based dielectric capping layer sandwiched in between the first dielectric capping layer and the control electrode, whereby the first dielectric capping layer is selected to determine the second effective work function. The control electrode of the first transistor has substantially the same composition and same thickness as the control electrode of the second transistor, and the Hf-based dielectric capping layer of the first transistor has substantially the same composition and same thickness as the Hf-based dielectric capping layer of the second transistor.

In embodiments of the present invention, the underlying layer may be the host dielectric layer. It is an advantage of such embodiments of the present invention that a same dielectric material, also referred to as host dielectric material, is used for different semiconductor structures of a semiconductor device. Since one host dielectric material is used for the different semiconductor structures, the process comes close to well-known conventional CMOS processes and gives better control of the integrity performance of the control electrode dielectric material.

In alternative embodiments, the underlying layer may be the substrate.

In embodiments of the present invention, the control electrode may be made from a metal comprising material. The metal comprising material may comprise any of a metal, a metal alloy, a metal silicide, a conductive metal nitride or a conductive metal oxide. Said electrode material may comprise Ta, Hf, Mo, W or Ru. In alternative embodiments said electrode material may also be polysilicon. In yet alternative embodiments, said first and/or second electrode may be a silicided electrode. Said silicided first and/or second electrode are preferably fully silicided.

In embodiments of the present invention, the first region and the second region may be of different, e.g. opposite, dopant types. In particular embodiments, the first region may be an NMOS region and the second region may be a PMOS region. In such embodiments, the first dielectric capping layer may for example be an Al-based dielectric. In alternative particular embodiments, the first region may be a PMOS region and the second region may be an NMOS region. In such embodiments, the first dielectric capping layer may for example be a lanthanide-based dielectric or an Sc-based dielectric.

In embodiments of the present invention, the thickness of the Hf-based dielectric layer may be 1 to 10 cycles ALD. In alternative embodiments, the thickness of the Hf-based dielectric layer may be between 1 and 2 nm.

In embodiments of the present invention, the Hf-based dielectric layer may comprise HfLaO. In particular embodiments it may consist of HfLaO.

In embodiments of the present invention, the host dielectric layer may be selected from the group consisting of Si02, SiON, Hf02, Zr02 and mixtures thereof.

Particular and preferred aspects of the invention are set out in the accompanying independent and dependent claims. Features from the dependent claims may be combined with features of the independent claims and with features of other dependent claims as appropriate and not merely as explicitly set out in the claims.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

All drawings are intended to illustrate some aspects and embodiments of the present invention. The drawings described are only schematic and are nonlimiting.

Figures 1 to 3 represent schematically an integration route for forming a gate stack of a semiconductor device comprising a first region and a second region in accordance with embodiments of the present invention.

Figures 4 to 6 represent schematically an alternative integration route for forming a gate stack of a semiconductor device comprising a first region and a second region in accordance with embodiments of the present invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are nonlimiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

All numbers expressing thicknesses and so forth used in the specification and claims are to be understood as being modified in all instances by the term "about". Accordingly, unless indicated to the contrary, the numerical parameters set forth in the specification and attached claims are approximations that may vary depending upon the desired properties sought to be obtained by the present invention. At the very least, each numerical parameter should be construed in light of the number of significant digits and ordinary rounding approaches.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing embodiment of the present invention. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

Various embodiments of the invention are referring to parameters of the semiconductor device such as threshold voltage, effective work function (eWF), or physical characteristics of the material(s) employed such as work function, Fermi level etc. The definitions as used through this document are summarized herein-below.

In the following, certain embodiments will be described with reference to device structures such as field effect transistors having two main electrodes and a control electrode, but the inventive aspect is not limited thereto. In the following, certain embodiments will also be described with reference to a silicon substrate but is should be understood that certain inventive aspects apply equally well to other semiconductor substrates. In embodiments, the substrate may include a semiconductor substrate such as e.g. a silicon, a gallium arsenide (GaAs), a gallium arsenide phosphide (GaAsP), an indium phosphide (InP), a germanium (Ge) or a silicon germanium (SiGe) substrate. The substrate may include for example an insulating layer such as a SiO₂ or a Si₃N₄ layer in addition to a substrate portion. Thus, the term substrate also includes silicon-on-glass, silicon-on-sapphire substrates. The term substrate is thus used to define generally the elements for layers that underlie a layer or portion(s) of interest. Also, the substrate may be any other base on which a layer is formed, for example a glass or metal layer. Accordingly a substrate may be a wafer such as a blanket wafer or may be a layer applied to another base material, e.g. an epitaxial layer grown onto a lower layer.

Some embodiments are suitable for integration into CMOS processing to provide CMOS devices. In such processing active regions can be formed by doping a semiconductor layer. An active region is defined as any region which becomes active due to the implantation of a dopant such as As, B, Ph, Sb, etc. In a MOS device this active region is often referred to as source and/or drain region. However, certain inventive aspects are not limited thereto.

A MOSFET device comprises a first and second main electrode, e.g. source and drain electrode, at first and second extremities of a channel, and a control electrode, e.g. a gate electrode, for controlling the conductivity of the channel. When using a MOSFET device, a threshold voltage (Vt) needs to be applied to the gate to render the channel conductive. Complementary MOS processes fabricate both n-channel and p-channel (NMOS and PMOS) transistors. The threshold voltage is influenced by what is called the effective work function difference. To establish threshold voltage (Vt) values, the effective work function differences of the respective PMOS and NMOS gate materials (gate stacks) and their corresponding channel regions are independently established through channel processing and gate processing. In other words, both gate dielectric (consisting e.g. of a host dielectric and different capping layers) and gate electrode (consisting i.e. of at least one metal layer) determine the effective work function of the gate stack (device). Moreover, the gate processing itself (i.e. the sequence of the different steps and/or the thermal treatments applied) may have an influence on the effective work function of the gate stack (device).

The effective work function of a gate stack (device) is a parameter that can be tuned by the choice of the gate dielectric materials, gate electrode materials and by the gate processing performed. On the contrary, the work function of the gate electrode (often referred to as metal gate electrode or metal layer) is an intrinsic property of the material. In general, the work function of a certain material (e.g. a metal layer) is a measure of the energy, in electron volts (eV), required to eject an electron in the material outside of a material atom to the vacuum, if the electron were initially at the Fermi level.

For a silicon substrate, the gate electrode of a negative channel MOSFET (or NMOS) device would have an n-type work function of approximately 4.1 eV (+/-0.3 eV), and the gate electrode of a positive channel MOSFET (or PMOS) device would have a p-type work function of approximately 5.2 eV (+/-0.3 eV).

Where, herein, a specific chemical name or formula is given, the material may include non-stoichiometric variations of the stoichiometrically exact formula identified by the chemical name. Lack of numerical subscript by an element in the formula stoichiometrically signifies the number one. Variations in the range plus/minus 20% of the exact stoichiometric number are comprised in the chemical name or formula, for the purposes of the present invention. Where an algebraic subscript is given, then variations in the range plus/minus 20% relative to the value of each subscript are considered to form embodiments of the present invention. Such varied values do not necessarily sum to a whole number and this departure is contemplated. Such variations may occur due to either intended selection and control of the process conditions, or due to unintended process variations.

The invention will now be described by a detailed description of several embodiments of the invention. It is clear that other embodiments of the invention can be configured according to the knowledge of persons skilled in the art without departing from the technical teaching of the invention as defined by the appended claims.

In a first aspect, the present invention provides a method for manufacturing a dual work function semiconductor device.

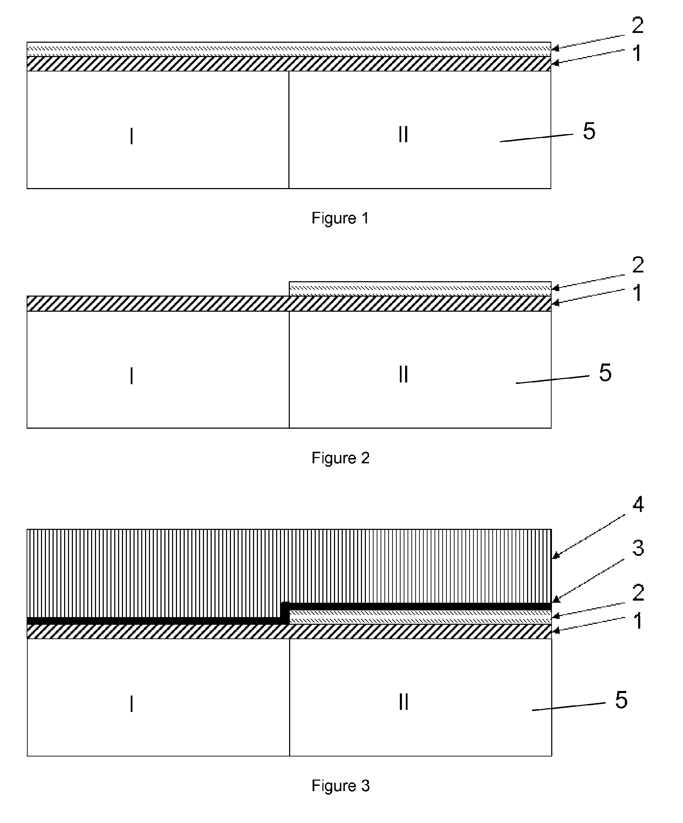

In a first embodiment of the first aspect, illustrated in Figures 1, 2 and 3, the method comprises providing a substrate 5, and defining at least a first region I and a second region II in said substrate 5, the first region I being different from the second region II. The substrate may be any type of substrate as described above. With first region I is meant at least part of the substrate 5. With second region II is meant at least another part of the substrate 5. The first region I and the second region II are distinct regions. There is no overlap between the first region I and the second region II. The first region I and the second region II may be separated using isolation between said first and second region (not illustrated in the drawings), such as for example shallow trench isolation (STI) zones or local oxidation of silicon (LOCOS) zones. Alternatively, mesa isolation may be used as for example in the case when a silicon-on-insulator (SOI) substrate is used.

The method comprises forming a first control electrode stack, e.g. gate stack, on the first region I, the first control electrode stack having a first effective work function, and forming a second control electrode stack, e.g. gate stack, on the second region II, the second control electrode stack having a second effective work function, each control electrode stack comprising a control electrode dielectric 1, 3; 1, 2, 3 and a control electrode 4, e.g. a metal control electrode. Forming the control electrode stacks, i.e. forming the control electrode dielectrics 1, 3; 1, 2, 3 and the control electrodes 4 may comprises some or all of the following steps:
(i) Optionally, in a first step the surface of the substrate 5 may be pre-cleaned with standard cleaning techniques, such as for example RCA clean, to remove any organic contaminants or native oxide on the wafer substrate or semiconductor substrate.
(ii) Forming a host dielectric layer 1 overlying both the first region I and the second region II of the substrate 5, as illustrated in Figure 1. Said host dielectric layer 1 may cover the whole substrate 5 or only parts thereof. With host dielectric material is meant that the dielectric material is used for the main purpose as a control electrode dielectric, e.g. gate dielectric, in a semiconductor device, namely as a dielectric barrier between the control electrode, e.g. gate electrode, and a channel region of the semiconductor structures forming the semiconductor device. In embodiments of the present invention, the host dielectric layer 1 is selected from the group consisting of SiO₂, SiON, HfO₂, ZrO₂ and mixtures thereof. The host dielectric layer 1 may be deposited by chemical-vapor-deposition (CVD) techniques. Most commonly used are metal organic CVD (MOCVD) and atomic layer deposition (ALD). Alternatively, said host dielectric layer 1 maybe deposited with other suitable deposition techniques known to a person skilled in the art.
(iii) Optionally, to improve the electrical characteristics of the host dielectric layer 1, post-deposition annealing (PDA) may be performed.
(iv) In a next step, a first dielectric capping layer 2 is formed overlying the host dielectric layer 1 on the first region I and on the second region II, as illustrated in Figure 1, wherein the first dielectric capping layer 2 is selected to determine, in co-operation with the host dielectric layer 1, the effective work function of the second control electrode stack. Said first dielectric capping layer 2 is on and in contact with said underlying host dielectric layer 1. With 'in contact with' is meant that the first dielectric capping layer 2 is in direct contact with the host dielectric layer 1 which is positioned in between the substrate 5 and the first dielectric capping layer 2. Said first dielectric capping layer 2 may be provided by any suitable method, such as deposition techniques, for example CVD, ALD or PVD techniques. Alternatively, said first dielectric capping layer 2 may be deposited with other suitable low temperature deposition techniques known to a person skilled in the art. According to embodiments of the present invention the first dielectric capping layer 2 may comprise a dielectric material which can tune the work function of a control electrode stack formed by completing subsequent steps. In embodiments of the present invention, said dielectric material may be an Al-based dielectric, for example AlOx, with 0<x<2. In alternative embodiments, the dielectric material may be a lanthanide-based or an Sc-based dielectric. The dielectric may for example be a dielectric selected from the group consisting of DyOx, LaOx or ScOx (with 0<x<2) and mixtures thereof.
(v) Thereafter, at least the first dielectric capping layer 2 is patterned so that the first dielectric capping layer 2 is selectively removed at least on the first region I, the selectivity of the removal of the first dielectric capping layer being towards to the host dielectric layer 1, thereby exposing the host dielectric layer 1 on the first region I, as illustrated in Figure 2. The patterning is such that the first dielectric capping layer 2 remains on and in contact with the host dielectric layer 1 on the second region II. For patterning the first dielectric capping layer 2, a masking material (not illustrated) may be deposited on said first dielectric capping layer 2, such as for example resist, followed by a lithographic step. This lithographic step may comprise exposing the resist using a mask, followed by patterning the exposed region such that the exposed zone, e.g. the zone above the first region I, is removed. Alternatively, and depending on the kind of lithography used, the zone above the second region II may be exposed and the unexposed part of the resist, i.e. the resist above the first region I, may be removed. After said lithographic step, said first dielectric capping layer 2 may be removed, e.g. etched using a dry or wet etching technique depending on the material of the first dielectric capping layer 2.
(vi) In a next step, a Hf-based dielectric capping layer 3 is formed overlying the host dielectric layer 1 on the first region I and the first dielectric capping layer 2 on the second region II, as illustrated in Figure 3, wherein the Hf-based dielectric capping layer 3 is selected to have a healing effect on the exposed surface of the host dielectric layer 1 on the first region I. Healing is the repair of the exposed surface of the host dielectric layer 1 which is damaged by the removal step, e.g. selective etch step, of the first dielectric capping layer 2. The damage comprises surface defects and dangling bonds originating from the interaction between the etch chemicals and the host dielectric layer 1, which act as interface traps and affect the electrical performance of the device. Providing the Hf-based dielectric capping layer 3 saturates the previously generated defects. The Hf-based dielectric capping layer 3 should be conformal with a good uniformity in thickness and composition over the substrate. The conformality is an intrinsic characteristic of ALD, good uniformity can be achieved. Furthermore, the Hf-based dielectric capping layer 3 should have a stable interface with the control electrode, e.g. no intermixing, good adhesion. In embodiments wherein the layer underlying the Hf-based capping layer 3 is the host dielectric layer 1, the Hf-based dielectric capping layer 3 should be thin (1-10 cycle ALD) with a minor contribution to EOT. In alternative embodiments wherein the layer underlying the Hf-based dielectric capping layer 3 is the substrate 5, the Hf-based dielectric capping layer 3 should have a good quality interface with the substrate 5 (e.g. no defects) and should have a good uniformity in thickness and composition over the substrate 5. In these embodiments the Hf-based dielectric capping layer 3 will later on form the control electrode dielectric, e.g. gate dielectric, on the first region I.
(vii) In a next step a control electrode 4 is formed overlaying the Hf-based dielectric capping layer 3 on the first region I and on the second region II, as illustrated in Figure 3. A first control electrode may be formed on the first region I, and a second control electrode may be formed on the second region II. According to embodiments of the present invention, the first electrode may be the same as the second electrode, or in other words the first and second electrode may be formed of a same layer of electrode material, as illustrated in Figure 3. Said first and/or second electrode material may comprise a metal comprising material to form a metal gate. With metal comprising material is understood metals, metal alloys, metal silicides, conductive metal nitrides, conductive metal oxides, ... For example the metal comprising material may comprise Ta, Hr, Mo, W or Ru or may comprises Ta-based metals such as TaCₓN_{y}. Said electrode may alternatively comprise polysilicon or may be a fully silicided (FUSI) metal electrode. In FUSI technology, a thin polysilicon electrode is deposited as in a conventional CMOS process. Next a metal (e.g. nickel or hafnium) is then deposited and followed by rapid thermal annealing (RTA) to fully silicidise the electrode.
(viii) After depositing the control electrode 4, further process steps may be performed as in conventional CMOS processing. Said process steps may comprise patterning the control electrode and the dielectric stack, implantation steps to form first and second main electrode regions, e.g. source and drain regions in said first region I and said second region II, formation of spacers aside the control electrodes, etc.

Advantageously, a method according to embodiments of the present invention improves leakage performance of dual workfunction semiconductor devices, due to the healing (repair) effect of the Hf-based dielectric capping layer 3 on the exposed surface of the host dielectric 1, previously damaged by the selective removal step, e.g. a selective etch step of the first dielectric capping layer 1 (surface defects by the removal of the first dielectric capping layer 1, dangling bonds). More advantageously, the Hf-based dielectric capping layer 3 has essentially no influence on the effective work function of the first and second control electrode stacks.

An advantage of the method according to embodiments of the present invention is that the Hf-based dielectric capping layer 3 does not have to be selectively removed from the first capping layer 2 or from the host dielectric layer 1 on one of the regions. This reduces damage of the underlying layers, hence deterioration of the device, e.g. leakage.

It is a further advantage of embodiments of the present invention that no sacrificial layers need to be applied in order to manufacture a dual workfunction semiconductor device in accordance with embodiments of the present invention. This makes the workflow easier.

It is particularly difficult to find a dielectric material suitable as first dielectric capping layer 2 (having a high k-value and the right contribution on the effective work function tuning) and, at the same time, showing enough selectivity towards another dielectric material (host dielectric 1) and towards a photoresist mask material as used in standard semiconductor layer removal processes, e.g. wet chemical solutions.

In one type of embodiments of the first aspect of the invention, the first region I is an NMOS region and the second region II is a PMOS region. Further in the same type of embodiments the first dielectric capping layer 2 may be an Al-based dielectric. In particular embodiments, the first dielectric capping layer 2 may consist of aluminum oxide (AlOₓ, with 0<x<2).

In another type of embodiments of the first aspect of the invention, the first region I is a PMOS region and the second region II is an NMOS region. In particular embodiments of this type of embodiments, the first dielectric capping layer 2 may be a lanthanide-based dielectric or an Sc-based dielectric. In particular embodiments, the first dielectric capping layer 2 may be a dielectric selected from the group comprising or consisting of D_{y}Oₓ, LaOₓ, ScOₓ (with 0<x<2) and mixtures thereof.

In some embodiments of the invention, the Hf-based dielectric capping layer 3 consists of HfLaO.

In embodiments of the invention, the thickness of the Hf-based dielectric capping layer 3 is about 1 to 10 cycles ALD (Atomic Layer Deposition). The method according to embodiments of the present invention has the additional advantage that a dual work function device can be manufactured with a minor EOT (equivalent oxide thickness) increase, due to the very thin capping layers 3 employed.

In embodiments of the invention, the host dielectric layer 1 may be selected from the group comprising or consisting of SiO₂, SiON, HfO₂, ZrO₂ and mixtures thereof. The control electrode dielectric 1, 2, 3 may further comprise an interfacial layer (not illustrated in the drawings), in contact with the semiconductor substrate 5 and underlying the host dielectric layer 1. Such interfacial layer may be formed as a result of an optional pre-cleaning process step, prior to forming the host dielectric layer 1. In embodiments of the present invention, this interfacial layer may consist of an oxide of the semiconductor material of the substrate 5 (e.g. SiO₂). In embodiments of the present invention, the interfacial layer may have a thickness lower than 0.7 nm, preferably lower than 0.4 nm.

Selecting SiO₂, SiON, HfO₂, ZrO₂ or combinations thereof as host dielectric layer 1 and a Hf-based dielectric (in particular for example HfLaO) as a second dielectric capping layer 3 has the additional advantage of minimizing the impact of a change of used dielectric material; which change of material is generally known to often require expensive adaptations in a manufacturing flow (dedication of tools, expensive/hazardous precursors, etc.) . In this way, the integration route chosen matches the classic (existing) integration routes, mostly using a SiON dielectric as a host dielectric in contact with the substrate.

In different embodiments of the invention the control electrode 4 can be a metal electrode made of at least one layer of metal or a FUSI (Fully silicided) electrode.

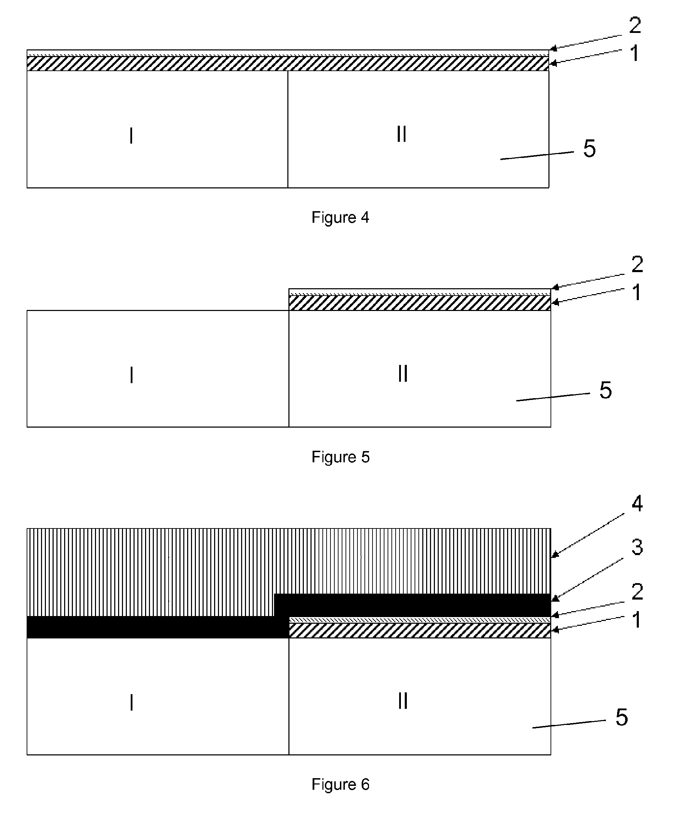

In an alternative embodiment of the first aspect of the invention, illustrated in Figures 4, 5 and 6 a method for manufacturing a dual work function semiconductor device is disclosed. The method comprises providing a substrate 5 with a first region I and a second region II, forming a first control electrode stack, e.g. gate stack, on the first region I, the first control electrode stack having a first effective work function, and forming a second control electrode stack, e.g. gate stack, on the second region II, the second control electrode stack having a second effective work function, each control electrode stack comprising a control electrode dielectric 3; 1, 2, 3 and a control electrode 4, e.g. a metal control electrode. The process of forming the control electrode stacks on the first region I and the second region II, the control electrode stacks comprising control electrode dielectric 3; 1, 2, 3 and the control electrode 4, comprises at least:
(i) forming a host dielectric layer 1 overlying the first region I and the second region II of the substrate 5, as illustrated in Figure 4,
(ii) forming a first dielectric capping layer 2 overlying the host dielectric layer 1 on the first region I and on the second region II, as illustrated in Figure 4, wherein the first dielectric capping layer 2 is selected to determine, in co-operation with the host dielectric layer 1, the effective work function of the second control electrode stack,
(iii) removing the first dielectric capping layer 2 and the host dielectric layer 1 selectively to the substrate 5 on the first region I, thereby exposing the substrate 5 on the first region I, as illustrated in Figure 5,
(iv) forming a Hf-based dielectric capping layer 3 overlying the substrate 5 on the first region I and overlying the first dielectric capping layer 2 on the second region II, as illustrated in Figure 6, wherein the Hf-based dielectric capping layer 3 is selected to have a healing effect on the exposed surface of the substrate 5 on the first region I, and
(v) forming a control electrode 4 overlaying the Hf-based dielectric capping layer 3 on the first region I and on the second region II, as illustrated in Figure 6.

In this embodiment, an alternative integration route is disclosed, wherein both the host dielectric layer 1 and the first dielectric capping layer 2 are removed selectively towards the substrate 5 on the first region I. This alternative integration route presents the advantage of avoiding a selective removal step, e.g. a selective etch, of the first dielectric capping layer 2 stopping on the host dielectric layer 1. Selectivity concerns, e.g. with regard to etching an AIO layer 2 stopping on a SiON layer 1, are in this way avoided. In this embodiment both the first dielectric capping layer 2 and the host dielectric layer 1 are removed on the first region I, the removal stopping on the substrate 5.

Other process steps, material details, features of the layers, etc. as disclosed with respect to the first embodiment of the first aspect of the present invention, although not repeated here, also apply to this second embodiment of the first aspect of the present invention or can be combined therewith.

The Hf-based dielectric layer 3 deposited in this alternative integration route may be thicker than 1-10 cycles ALD. In embodiments of the present invention, the thickness of the Hf-based dielectric layer 3 may for example range between about 1-2 nm, since the Hf-based dielectric layer 3 will act as a main dielectric layer (in contact with the substrate 5) on the first region I. Alternatively, the Hf-based dielectric layer 3 may comprise another Hfbased material such as HfO2 or HfSiON.

The first dielectric capping layer 2 may in this alternative integration route be thinner that in the previous embodiment in order to keep the EOT value of the control electrode dielectric stack essentially unchanged.

In a second aspect of the present invention, a dual work function semiconductor device is provided, comprising a first transistor on a first substrate region I, the first transistor having a first effective work function, and a second transistor on a second substrate region II, the second transistor having a second effective work function.

In a first embodiment of the second aspect, the first transistor comprises a host dielectric layer 1 overlying and in contact with a substrate 5, a control electrode 4, e.g. a metal control electrode 4, and a Hf-based dielectric capping layer 3 sandwiched in between the host dielectric layer 1 and the control electrode 4. The second transistor comprises a host dielectric layer 1 overlying and in contact with the substrate 5, a control electrode 4, e.g. a metal control electrode 4, a first dielectric capping layer 2 overlying the host dielectric layer 1, and a Hf-based dielectric capping layer 3 sandwiched in between the first dielectric capping layer 2 and the control electrode 4, e.g. metal control electrode, whereby the first dielectric capping layer 2 is selected to determine the second effective work function. In embodiments of the present invention, the host dielectric layer 1 of the first transistor has substantially the same composition and same thickness as the host dielectric layer 1 of the second transistor. The control electrode 4 of the first transistor has substantially the same composition and same thickness as the control electrode 4 of the second transistor. The Hf-based dielectric capping layer 3 of the first transistor has substantially the same composition and same thickness as the Hf-based dielectric capping layer 3 of the second transistor.

For the avoidance of doubt, the term "a Hf-based dielectric capping layer 3 sandwiched in between the host dielectric layer 1 and the control electrode 4" used herein refers to a Hf-based dielectric capping layer 3 overlying and in contact with the host dielectric layer 1 and underlying and in contact with the control electrode 4. Analogously, "a Hf-based dielectric capping layer 3 sandwiched in between the first dielectric capping layer 2 and the control electrode 4" refers to a Hf-based dielectric capping layer 3 overlying and in contact with the first dielectric capping layer 2 and underlying and in contact with the control electrode 1.

In one type of embodiments of the second aspect of the invention the first region I is an NMOS region and the second region II is a PMOS region. Further in the same type of embodiments, the first dielectric capping layer 2 may be an Al-based dielectric. In particular embodiments, the first dielectric capping layer 2 may consists of aluminum oxide (AlOx, with 0<x<2).

In another type of embodiments of the second aspect of the invention, the first region I is a PMOS region and the second region II is an NMOS region. Further in the same type of embodiments, the first dielectric capping layer 2 may be a lanthanide-based dielectric or an Sc-based dielectric. In particular embodiments, the first dielectric capping layer 2 may be a dielectric selected from the group comprising or consisting of DyOx, LaOx, ScOx (with 0<x<2) and mixtures thereof.

In one particular embodiment of the first embodiment of the second aspect of the invention, the thickness of the Hf-based dielectric 3 is from about 1 to 10 cycles ALD.

In another particular embodiment of the second aspect of the invention, the Hf-based dielectric 3 consists of HfLaO.

In a second embodiment of the second aspect, the first transistor comprises a control electrode 4, e.g. a metal control electrode 4, and a Hf-based dielectric capping layer 3 sandwiched in between a substrate 5 and the control electrode 4. The second transistor comprises a host dielectric layer 1 overlying and in contact with the substrate 5, a control electrode 4, e.g. a metal control electrode 4, a first dielectric capping layer 2 overlying the host dielectric layer 1, and a Hf-based dielectric capping layer 3 sandwiched in between the first dielectric capping layer 2 and the control electrode 4, e.g. metal control electrode, whereby the first dielectric capping layer 2 is selected to determine the second effective work function. In embodiments of the present invention, the control electrode 4 of the first transistor has substantially the same composition and same thickness as the control electrode 4 of the second transistor. The Hf-based dielectric capping layer 3 of the first transistor has substantially the same composition and same thickness as the Hf-based dielectric capping layer 3 of the second transistor.

For the avoidance of doubt, the term "a Hf-based dielectric capping layer 3 sandwiched in between a substrate 5 and the control electrode 4" used herein refers to a Hf-based dielectric capping layer 3 overlying and in contact with the substrate 5 and underlying and in contact with the control electrode 4. Analogously, "a Hf-based dielectric capping layer 3 sandwiched in between the first dielectric capping layer 2 and the control electrode 4" refers to a Hf-based dielectric capping layer 3 overlying and in contact with the first dielectric capping layer 2 and underlying and in contact with the control electrode 1.

In one particular embodiment of the second embodiment of the second aspect of the invention, the thickness of the Hf-based dielectric 3 may for example range between about 1-2 nm. In particular embodiments of the second aspect of the invention, the Hf-based dielectric 3 may consist of HfLaO. Alternatively, the Hf-based dielectric layer 3 may comprise a Hf-based dielectric material such as HfLaO, or another Hf-based material such as HfO₂ or HfSiON, or combinations of one or more of these materials.

Other features of the layers, as disclosed with respect to the first embodiment of the second aspect of the present invention, although not repeated here, also apply to this second embodiment of the second aspect of the present invention.

The foregoing embodiments can be applied in different areas of semiconductor device manufacturing. While these embodiments are described in conjunction with a MOS transistor and more particularly to a planar a CMOS device, it will be apparent to those ordinary skilled in the art that the benefits of these embodiments can be applied to other transistor architectures such as MUltiple Gate FET transistors (MUGFET's) and other structures such as memory cell capacitors or other memory circuits. In particular, one ordinary skilled in the art can imagine other situations where similar electrical and physical properties are desired.

The foregoing description details certain embodiments of the invention. It will be appreciated, however, that no matter how detailed the foregoing appears in text, the invention may be practiced in many ways. It should be noted that the use of particular terminology when describing certain features or aspects of the invention should not be taken to imply that the terminology is being re-defined herein to be restricted to include any specific characteristics of the features or aspects of the invention with which that terminology is associated.

While the above-detailed description has shown, described, and pointed out novel features of the invention as applied to various embodiments, it will be understood that various omissions, substitutions, and changes in the form and details of the device or process illustrated may be made by those skilled in the art without departing from the scope of the invention as defined by the appended claims.

## Claims

1. A method for manufacturing a dual work function semiconductor device, comprising:
- providing a substrate (5) with a first region (I) and a second region (II);
- forming a first control electrode stack on the first region (I), the first control electrode stack having a first effective work function, and forming a second control electrode stack on the second region (II), the second control electrode stack having a second effective work function wherein each control electrode stack comprises a control electrode dielectric (1, 3; 1, 2, 3; 3) and a control electrode (4), the process of forming the control electrode stacks comprising:
(i) forming a host dielectric layer (1) overlying the first region (I) and the second region (II) of the substrate (5),
(ii) forming a first dielectric capping layer (2) overlying the host dielectric layer (1) on the first region (I) and on the second region (II), wherein the first dielectric capping layer (2) is selected to determine the second effective work function,
(iii) removing at least the first dielectric capping layer (2) selectively to an underlying layer (1; 5) on the first region (I), thereby exposing the underlying layer (1; 5) on the first region (I),
(iv) forming a Hf-based dielectric capping layer (3) overlying the underlying layer (1; 5) on the first region (I) and the first dielectric capping layer (2) on the second region (II), wherein the Hf-based dielectric capping layer (3) is selected to have a healing effect on the exposed surface of the underlying layer (1; 5) on the first region (I), and
(v) forming a control electrode (4) overlaying the Hf-based dielectric capping layer (3) on the first region (I) and on the second region (II).

2. A method according to claim 1, wherein the underlying layer is the host dielectric layer (1).

3. A method according to claim 1, wherein the underlying layer is the substrate (5).

4. A method according to any of the previous claims, wherein forming the Hf-based dielectric capping layer (3) comprises depositing the Hf-based dielectric capping layer (3) by ALD.

5. A dual work function semiconductor device, comprising a first transistor on a first region (I) of a substrate (5), the first transistor having a first effective work function, and a second transistor on a second region (II) of the substrate (5), the second transistor having a second effective work function, the first transistor comprising an underlying layer (1; 5), a control electrode (4) and a Hf-based dielectric capping layer (3) sandwiched in between the underlying layer (1; 5) and the control electrode, the second transistor comprising a host dielectric layer (1) overlying and in contact with the substrate (5), a control electrode (4), a first dielectric capping layer (2) overlying the host dielectric layer (1) and a Hf-based dielectric capping layer (3) sandwiched in between the first dielectric capping layer (2) and the control electrode (4), whereby the first dielectric capping layer (2) is selected to determine the second effective work function, wherein the control electrode (4) of the first transistor has substantially the same composition and same thickness as the control electrode (4) of the second transistor, and the Hf-based dielectric capping layer (3) of the first transistor has substantially the same composition and same thickness as the Hf-based dielectric capping layer (3) of the second transistor.

6. A dual work function semiconductor device according to claim 5, wherein the underlying layer is the host dielectric layer (1).

7. A dual work function semiconductor device according to claim 5, wherein the underlying layer is the substrate (5).

8. A dual work function semiconductor device according to any of claims 5 to 7, wherein the control electrode (4) is a metal control electrode.

9. A dual work function semiconductor device according to any of claims 5 to 8, wherein the first region (I) is an NMOS region and the second region (II) is a PMOS region.

10. A dual work function semiconductor device according to claim 9, wherein the first dielectric capping layer (2) is an Al-based dielectric.

11. A dual work function semiconductor device according to any of claims 5 to 8, wherein the first region (I) is a PMOS region and the second region (II) is an NMOS region.

12. A dual work function semiconductor device according to claim 11, wherein the first dielectric capping layer (2) is a lanthanide-based dielectric or an Sc-based dielectric.

13. A dual work function semiconductor device according to any of claims 5 to 12, wherein the thickness of the Hf-based dielectric layer (3) is 1 to 10 cycles ALD.

14. A dual work function semiconductor device according to any of claims 5 to 13, wherein the Hf-based dielectric layer (3) comprises HfLaO.

15. A dual work function semiconductor device according to any of claims 5 to 14, wherein the host dielectric layer (1) is selected from the group consisting of Si02, SiON, Hf02, Zr02 and mixtures thereof.

## Amended claims

### Amended claims in accordance with Rule 137(2) EPC.

**1.** A method for manufacturing a dual work function semiconductor device, comprising:
- providing a substrate (5) with a first region (I) and a second region (II);
- forming a first control electrode stack on the first region (I), the first control electrode stack having a first effective work function, and forming a second control electrode stack on the second region (II), the second control electrode stack having a second effective work function wherein each control electrode stack comprises a control electrode dielectric (1, 3; 1, 2, 3; 3) and a control electrode (4), the process of forming the control electrode stacks comprising:
(i) forming a host dielectric layer (1) overlying the first region (I) and the second region (II) of the substrate (5),
(ii) forming a first dielectric capping layer (2) overlying the host dielectric layer (1) on the first region (I) and on the second region (II), wherein the first dielectric capping layer (2) determines the second effective work function,
(iii) removing at least the first dielectric capping layer (2) selectively to an underlying layer (1; 5) on the first region (I), thereby exposing the underlying layer (1; 5) on the first region (I),
(iv) forming a Hf-based dielectric capping layer (3) overlying the underlying layer (1; 5) on the first region (I) and the first dielectric capping layer (2) on the second region (II), wherein the Hf-based dielectric capping layer (3) has a healing effect on the exposed surface of the underlying layer (1; 5) on the first region (1), and
(v) forming a control electrode (4) overlaying the Hf-based dielectric capping layer (3) on the first region (I) and on the second region (II).

**2.** A method according to claim 1, wherein the underlying layer is the host dielectric layer(1).

**3.** A method according to claim 1, wherein the underlying layer is the substrate (5).

**4.** A method according to any of the previous claims, wherein forming the Hf-based dielectric capping layer (3) comprises depositing the Hf-based dielectric capping layer (3) by ALD.

**5.** A dual work function semiconductor device, comprising a first transistor on a first region (I) of a substrate (5), the first transistor having a first effective work function, and a second transistor on a second region (II) of the substrate (5), the second transistor having a second effective work function, the first transistor comprising an underlying layer (1; 5), a control electrode (4) and a Hf-based dielectric capping layer (3) sandwiched in between the underlying layer (1; 5) and the control electrode, the second transistor comprising a host dielectric layer (1) overlying and in contact with the substrate (5), a control electrode (4), a first dielectric capping layer (2) overlying the host dielectric layer (1) and a Hf-based dielectric capping layer (3) sandwiched in between the first dielectric capping layer (2) and the control electrode (4), whereby the first dielectric capping layer (2) is selected to determine the second effective work function, wherein the control electrode (4) of the first transistor has the same composition and same thickness as the control electrode (4) of the second transistor, and the Hf-based dielectric capping layer (3) of the first transistor has the same composition and same thickness as the Hf-based dielectric capping layer (3) of the second transistor.

**6.** A dual work function semiconductor device according to claim 5, wherein the underlying layer is the host dielectric layer (1)

**7.** A dual work function semiconductor device according to claim 5, wherein the underlying layer is the substrate (5).

**8.** A dual work function semiconductor device according to any of claims 5 to 7, wherein the control electrode (4) is a metal control electrode.

**9.** A dual work function semiconductor device according to any of claims 5 to 8, wherein the first region (I) is an NMOS region and the second region (II) is a PMOS region.

**10.** A dual work function semiconductor device according to claim 9, wherein the first dielectric capping layer (2) is an Al-based dielectric.

**11.** A dual work function semiconductor device according to any of claims 5 to 8, wherein the first region (I) is a PMOS region and the second region (II) is an NMOS region.

**12.** A dual work function semiconductor device according to claim 11, wherein the first dielectric capping layer (2) is a lanthanide-based dielectric or a Sc-based dielectric.

**13.** A dual work function semiconductor device according to any of claims 5 to 12, wherein the Hf-based dielectric layer (3) comprises HfLaO.

**14.** A dual work function semiconductor device according to any of claims 5 to 13, wherein the host dielectric layer (1) is selected from the group consisting of SiO2, SiON, Hf02, Zr02 and mixtures thereof.
